# EUROPEAN PATENT APPLICATION

(11) **EP 4 794 009 A1**
(43) Date of publication of application: **19.08.2026**
(21) Application number: 26156842.2
(22) Date of filing: 06.02.2026
(51) Int. Cl.: H01M 4/131, H01M 4/525, H01M 4/505, H01M 4/1391

(54) **CATHODE LAYER, LITHIUM ION BATTERY, AND METHOD FOR PRODUCING CATHODE LAYER**

(30) Priority: 17.02.2025 JP 2025023666
(71) Applicant: Toyota Jidosha Kabushiki Kaisha, Toyota-shi, Aichi-ken 471-8571 (JP)
(72) Inventor: PROCTER, Momoko, Toyota-shi, 471-8571 (JP); MAHARA, Yuji, Toyota-shi, 471-8571 (JP)
(74) Representative: Kuhnen & Wacker Patent- und Rechtsanwaltsbüro PartG mbB

(57) **Abstract**

A main object of the present disclosure is to provide a cathode layer for a lithium ion battery, with which the resistance increase of a battery due to charge and discharge can be suppressed. The present disclosure achieves the object by providing a cathode layer to be used in a lithium ion battery, the cathode layer including: single crystalline active material configured by a crystalline primary particle containing Li, TM, which is a transition metal, and O as a cathode active material, wherein in a cross-section observation image of the cathode layer by a scanning electron microscope, the single crystalline active material includes a long side and a short side, an angle formed by the long side and the short side is 60° or more and 120° or less, and an aspect ratio which is a ratio of length of the long side to the short side is 1.2 or more, the long side of the single crystalline active material extends along (003) surface, and a ratio N_{B}/N_{A} of a number N_{B} of the single crystalline active material of which inclination of the long side direction to in-plane direction of the cathode layer is 0° or more and 30° or less, with respect to a number N_{A} of the single crystalline active material is 50% or more.

## Description

### Technical Field

The present disclosure relates to a cathode layer for a lithium ion battery, a lithium ion battery, and a method for producing a cathode layer.

### Background Art

In recent years, the development of a battery has been actively carried out. For example, the development of a battery used for battery electric vehicles (BEV), plug-in hybrid electric vehicles (PHEV), or hybrid electric vehicles (HEV) has been advanced in the automobile industry. As a cathode active material used for a battery, an active material including a transition metal such as Ni, Co, and Mn has been known.

In recent years, technology of orientating a specific crystal surface in an active material particle or an active material in a specific direction has been suggested. For example, Patent Literature 1 discloses a plate shape particle for cathode active material of lithium secondary battery formed as a polycrystal body of a plurality of primary crystal particles including a layered rock salt structure, wherein (003) surface of the primary crystal particle in the plate shape particle is orientated so as to be parallel to a plate surface of the plate shape particle. Patent Literature 2 discloses a method for producing a power storage device, the method including: an applying step of applying a slurry including an active material particle that is a material with an isotropy of magnetic susceptibility such as an olivine type oxide containing a transition metal element, on a current collector; and a step of leaving the current collector to which the slurry is applied, in a magnetic field. Patent Literature 3 discloses a non-aqueous electrolyte secondary battery wherein graphite-based anode active material is arranged so that a longer direction of the graphite-based anode active material is along with a surface direction of the current collector by applying magnetic field.

### Citation List

### Patent Literatures

Patent Literature 1: International Application Publication: WO 2012/046557
Patent Literature 2: Japanese Patent Application Laid-Open (JP-A) No. 2022-66604
Patent Literature 3: JP-A No. 2015-138644

### Summary of Disclosure

### Technical Problem

From the view point of improving performance of a battery, it has been required to suppress the increase of resistance along with charge and discharge of the battery. The present disclosure has been made in view of the above circumstances, and a main object thereof is to provide a cathode layer for lithium ion battery, with which the increase in resistance along with charge and discharge of the battery can be suppressed.

### Solution to Problem

[1] A cathode layer to be used in a lithium ion battery, the cathode layer comprising:
   a single crystalline active material configured by a crystalline primary particle containing Li, TM, which is a transition metal, and O as a cathode acti active material, wherein
   in a cross-section observation image of the cathode layer by a scanning electron microscope,
   the single crystalline active material includes a long side and a short side, an angle formed by the long side and the short side is 60° or more and 120° or less, and an aspect ratio which is a ratio of length of the long side to the short side is 1.2 or more,
   the long side of the single crystalline active material extends along (003) surface, and
   a ratio N_{B}/N_{A} of a number N_{B} of the single crystalline active material of which inclination of the long side direction to in-plane direction of the cathode layer is 0° or more and 30° or less, with respect to a number N_{A} of the single crystalline active material is 50% or more.
[2] The cathode layer according to [1], wherein a length of the long side of the single crystalline active material is 0.5 µm or more.
[3] The cathode layer according to [1] or [2], wherein the ratio N_{B}/N_{A} is 56% or more and 65% or less.
[4] The cathode layer according to any one of [1] to [3], wherein an outer shape of the single crystalline active material is a rectangular parallelepiped.
[5] The cathode layer according to any one of [1] to [4], wherein the primary particle includes at least Ni as the TM.
[6] The cathode layer according to any one of [1] to [5], wherein the primary particle contains at least one kind of Co and Mn as the TM.
[7] The cathode layer according to [5], wherein a molar ratio of the Ni to the TM is 0.5 or more.
[8] The cathode layer according to any one of [1] to [7], wherein a ratio of the single crystalline active material in the cathode active material is 50 weight% or more.
[9] The cathode layer according to any one of [1] to [8], wherein the primary particle includes a layered rock salt type crystal structure.
[10] The cathode layer according to any one of [1] to [9], wherein the primary particle includes a composition represented by LiₓNiₐCo_{b}Mn_{c}O_{y}, in which 0.1 ≤ x ≤ 1.5, 0.5 ≤ a ≤ 1.0, 0 ≤ b ≤ 0.3, 0 ≤ c ≤ 0.3, a+b+c = 1.0, and 1.5 ≤ y ≤ 2.1.
[11] A lithium ion battery comprising the cathode layer according to any one of [1] to [10].
[12] A method for producing the cathode layer according to any one of [1] to [10], the method comprising:
   an applying step of applying a cathode slurry including the cathode active material that contains the single crystalline active material to obtain a cathode layer precursor, and
   an orientating step of orientating the single crystalline active material so that an inclination of the long side direction to in-plane direction of the cathode layer becomes 0° or more and 30° or less by exposing the cathode layer precursor under magnetic field.

### Advantageous Effects of Disclosure

The present disclosure can provide a cathode layer for a lithium ion battery, with which the resistance increase of a battery due to charge and discharge can be suppressed.

### Brief Description of Drawings

FIG. 1 is a schematic view of the cross-section observation image of the cathode layer in the present disclosure by a scanning electron microscope.
FIG. 2 is an enlarged view of single crystalline active material P in a dotted frame in FIG. 1.
FIG. 3 is a schematic view showing the crystal structure of the single crystalline active material P in the cathode layer in the present disclosure.
FIG. 4 is a schematic view showing the production step of the cathode layer in the present disclosure.
FIG. 5 is a schematic cross-sectional view exemplifying the lithium ion battery in the present disclosure.
FIG. 6 is a schematic cross-sectional view exemplifying the lithium ion battery in the present disclosure.

### Description of Embodiments

The present disclosure will be hereinafter explained in details with reference to drawings. Each drawing described as below is an example, and the size and the shape of each portion may be exaggerated in order to be understood easily.

### A. Cathode layer

The cathode layer in the present disclosure is a cathode layer to be used in a lithium ion battery, the cathode layer including: a single crystalline active material configured by a crystalline primary particle containing Li, TM, which is a transition metal, and O as a cathode active material, wherein in a cross-section observation image of the cathode layer by a scanning electron microscope, the single crystalline active material includes a long side and a short side, an angle formed by the long side and the short side is 60° or more and 120° or less, and an aspect ratio which is a ratio of length of the long side to the short side is 1.2 or more, the long side of the single crystalline active material extends along (003) surface, and a ratio N_{B}/N_{A} of a number N_{B} of the single crystalline active material of which inclination of the long side direction to in-plane direction of the cathode layer is 0° or more and 30° or less, with respect to a number N_{A} of the single crystalline active material is 50% or more.

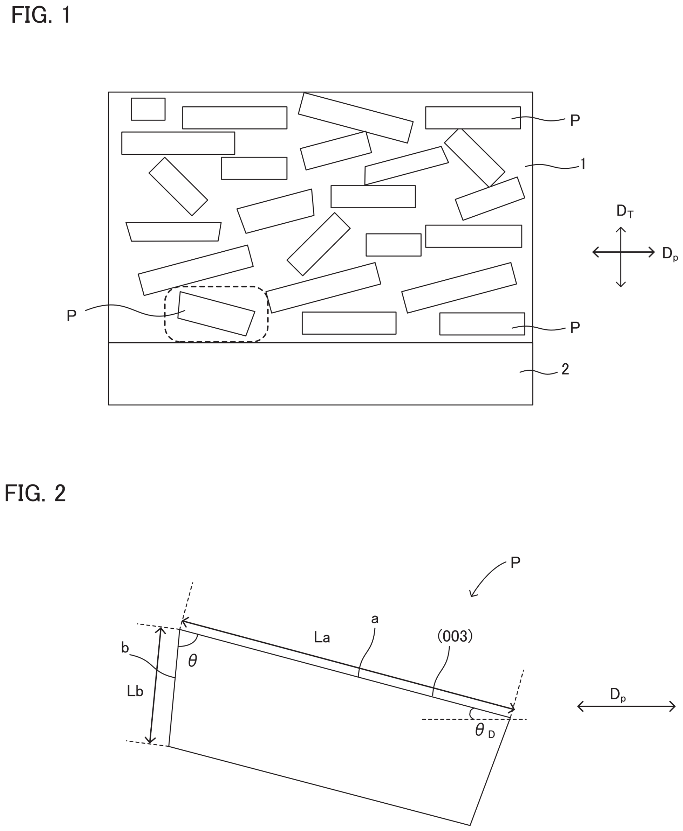

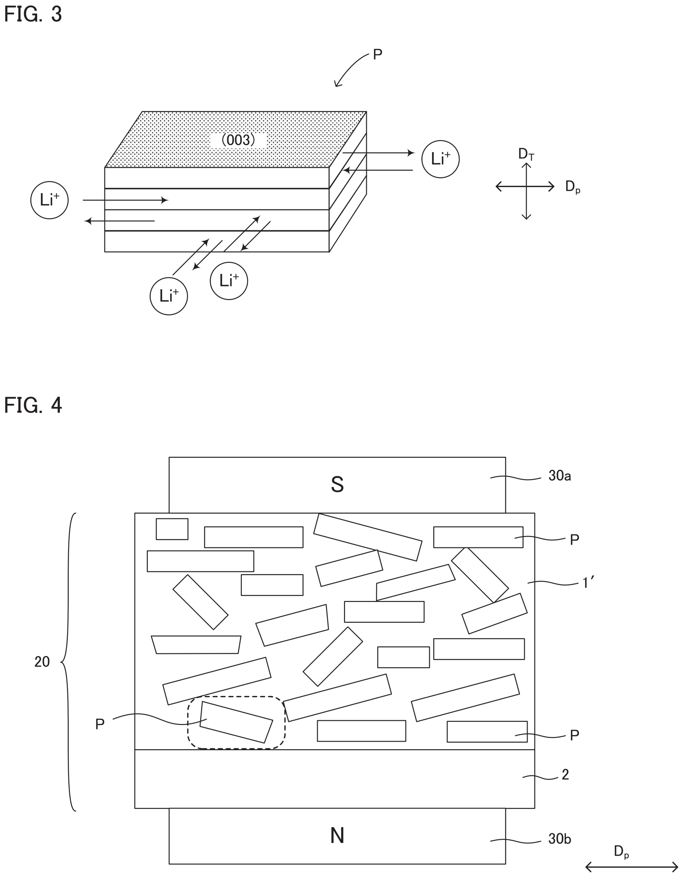

FIG. 1 is a schematic view of the cross-section observation image (hereinafter also referred to as a cross-section SEM image) of the cathode layer in the present disclosure by a scanning electron microscope. FIG. 2 is an enlarged view of single crystalline active material P in a dotted frame in FIG. 1. FIG. 3 is a schematic view showing the crystal structure of the single crystalline active material P in the cathode layer in the present disclosure. As shown in FIG. 1, the cathode layer 1 in the present disclosure includes a single crystalline active material P configured by a crystalline primary particle containing Li, TM, which is a transition metal, and O as a cathode active material. As shown in FIG. 2, in the cross-section SEM image of the cathode layer 1, the crystalline active material P includes a long side a and a short side b, an angle θ formed by the long side a and the short side b is 60° or more and 120° or less, and an aspect ratio La/Lb which is a ratio of length of the long side a to the short side b is 1.2 or more. In the present disclosure, the long side a of the single crystalline active material P extends along (003) surface. As shown in FIG. 3, the (003) surface is a crystal surface where lithium ion does not enter or exit.

As described above, a cathode layer capable of suppressing the increase of resistance along with charge and discharge of the battery has been required. In particular, although a layered type cathode active material including Ni is expected to increase the discharge capacity, it cannot avoid contraction and expansion to a layered direction (c-axis direction) of the crystal lattice due to charge and discharge, and as a result, cut-off of conduction path and deterioration of the crystal structure proceed to easily increase the resistance. This is presumably because Li ions are taken out from the Li layer at the time of charging and the Li layer contracts in the layered direction (c-axis direction), and the exchanging phenomenon (cation mixing) of Li ions in the Li layer and the Ni ions in the transition metal layer occurs to change a part of the layer structure to a rock salt structure. In particular, for example, when charge and discharge including a high potential region of 4.1 V or more is performed, the resistance increase is remarkable.

In contrast, in the present disclosure, the cathode active material includes the single crystalline active material P configured by the crystalline primary particle, and in the cross-section SEM image of the cathode layer 1, the crystalline active material P includes the specified shape and the long side a of the single crystalline active material P extends along the (003) surface. When the single crystalline active material is long in the (003) surface, it means that the Li layer is wide, and thus it is considered that the deposition of the Li ions from the Li layer can relatively slowly proceed. The Li ions remained in the Li layer work as it were a pillar to relax the contraction of the Li layer, and it is considered that the deterioration of the structure does not easily occur. However, even when using such a single crystalline active material P, resistance increase due to charge and discharge may not be sufficiently suppressed in some cases. In the present disclosure, as shown in FIG. 1 to FIG. 3, the single crystalline active material P is orientated so that an inclination of the long side a to an in-plane direction D_{P} of the cathode layer 1 is approximately parallel (0° or more and 30° or less), and thus the (003) surface where lithium ions does not enter or exit is orientated in an approximately vertical direction to the dispersion direction of lithium ions in the cathode layer (thickness direction D_{T} of the cathode layer). Thereby, even when charge and discharge are repeated, the durability of the crystal structure of the primary particle improves, and the resistance increase due to charge and discharge of the lithium ion battery can be suppressed. Incidentally, Patent Literature 1 does not describe about adjusting the direction of the plate shape particle. As a result, the resistance of the battery easily increases due to charge and discharge of the battery.

In the present disclosure, the longer direction (inclination of long side a) of the single crystalline active material is orientated so as to be approximately parallel to the in-plane direction of the cathode layer, and thus the direction of expansion and contraction of the single crystalline active material due to charge and discharge of the battery are aligned compared to the case where the longer direction of the primary particle is not adjusted. Also, in the single crystalline active material orientated in this manner, compared to the single crystalline active material in which the longer direction is orientated to orthogonally intersects the surface of the cathode layer, the force applied to the single crystalline active material due to expansion and contraction of the single crystalline active material is smaller. From the reasons above, cracks of the single crystalline active material are inhibited, and the resistance increase along with charge and discharge of the battery can be suppressed.

Incidentally, in the present disclosure, the cross-section SEM image of the cathode layer is obtained by, for example, performing processing of taking out the cross-section of the cathode layer by an ion milling device, and observing the cross-section of the cathode layer with a scanning electron microscope. The magnification of the cross-section SEM image may be, for example, 2000 times or more and may be 20000 times or less. As the scanning electron microscope, a SEM device "product name: SU8230" from Hitachi High-Technologies Corporation may be used. Various size measurements and shape analysis in the cross-section SEM image may be performed with, for example, an image analyzing software "ImageJ".

The cathode layer will be hereinafter described in details.

### 1. Cathode active material

The cathode layer in the present disclosure includes a cathode active material. The cathode active material in the present disclosure includes a single crystalline active material configured by a crystalline primary particle containing Li, TM, which is a transition metal, and O. In a cross-section observation image of the cathode layer by a scanning electron microscope, the single crystalline active material includes a long side and a short side, an angle formed by the long side and the short side is 60° or more and 120° or less, and an aspect ratio which is a ratio of length of the long side to the short side is 1.2 or more, the long side of the single crystalline active material extends along (003) surface, and a ratio N_{B}/N_{A} of a number N_{B} of the single crystalline active material of which inclination of the long side direction to in-plane direction of the cathode layer is 0° or more and 30° or less, with respect to a number N_{A} of the single crystalline active material is 50% or more.

The single crystalline active material means that it is not a so-called polycrystalline active material (active material wherein multiple of primary particles aggregate without gaps). The single crystalline active material usually does not aggregate, and is present as one independent particle. In the single crystalline active material, it is preferable that the particle boundary is not confirmed in a SEM observation (magnification of about 10 thousand times to 30 thousand times).

The single crystalline active material has an advantage such that the deterioration over time is less compared to the polycrystalline active material. Also, the polycrystalline active material configured by a secondary particle easily cracks, and a new surface inside is easily exposed. The new surface contacts and reacts with the liquid electrolyte to generate a resistance component. Meanwhile, in the cathode layer in the present disclosure, the cathode active material includes the single crystalline active material. In contrary to the polycrystalline active material, the stress is not easily applied to the single crystalline and cracks are not easily generated, and thus, the resistance increase along with charge and discharge can be suppressed compared to the polycrystalline active material.

The primary particle in the present disclosure contains Li, TM, which is a transition metal, and O. The primary particle may contain one kind of the transition metal, may contain two kinds of the transition metal, may contain three kinds of the transition metal, and may contain four or more kinds of the transition metal.

The transition metal is a metal belonging to the 3rd to the 11th groups in the periodic table. The transition metal included in the primary particle may be a metal belonging to the 3rd period, the 4th period, or the 5th period. Examples of the transition metal may include Ti, V, Cr, Mn, Fe, Co, Ni, Zr, Nb, La, and W.

The primary particle preferably contains at least Ni as the TM. The reason therefor is to obtain a cathode active material with excellent capacity properties. The molar ratio of Ni to the TM (all the transition metals included in the primary particle) is, for example, 0.25 or more, may be 0.33 or more, may be 0.50 or more, may be 0.70 or more, and may be 0.80 or more. The capacity properties improve when the ratio of Ni is increased.

The primary particle preferably contains at least one kind of Co and Mn as the TM.

The primary particle may or may not contain Co as the TM. The molar ratio of Co to the TM (all the transition metals included in the primary particle) is, for example, 0 or more, may be 0.05 or more, and may be 0.10 or more. Meanwhile, the molar ratio of Co to the TM is, for example, 0.40 or less and may be 0.20 or less.

The primary particle may or may not contain Mn as the TM. The molar ratio of Mn to the TM (all the transition metals included in the primary particle) is, for example, 0 or more, may be 0.05 or more, and may be 0.10 or more. Meanwhile, the molar ratio of Mn to the TM is, for example, 0.40 or less and may be 0.20 or less.

The primary particle preferably contains at least one kind of Ni, Co, and Mn as the TM. The total molar ratio of Ni, Co, and Mn to the TM (all the transition metals included in the primary particle) is, for example, 0.80 or more, may be 0.90 or more, and may be 0.95 or more. Incidentally, "the total of Ni, Co, and Mn" includes the case where the ratio of one kind or two kinds of Ni, Co, and Mn is 0.

The primary particle may contain other metal M¹ (including semimetal) other than Li and the TM, in addition to Li and the TM. Examples of the other metal M¹ may include metals belonging to the 12th to the 14th groups in the periodic table. Examples of the metals belonging to the 12th to the 14th groups may include Zn, Al, Si, Ga, Ge, In, and Sn.

The composition of the primary particle is not particularly limited, and may be a composition represented by, for example, the general formula LiₓNiₐCo_{b}Mn_{c}O_{y}, in which 0.1 ≤ x ≤ 1.5, 0.5 ≤ a ≤ 1.0, 0 ≤ b ≤ 0.3, 0 ≤ c ≤ 0.3, a+b+c = 1.0, and 1.5 ≤ y ≤ 2.1.

The x signifies the molar ratio of Li to the total of Ni, Co, and Mn, and is usually 0.1 or more, may be 0.4 or more, may be 0.6 or more, may be 0.8 or more, may be 1.0 or more, and may be 1.05 or more. Meanwhile, the x is usually 1.5 or less, may be 1.4 or less, and may be 1.2 or less.

The y signifies the molar ratio of O to the total of Ni, Co, and Mn, and is usually 1.5 or more, may be 1.6 or more, may be 1.7 or more, may be 1.8 or more, and may be 1.9 or more. Meanwhile, the y is usually 2.1 or less, and may be 2.0 or less.

The "a" signifies the molar ratio of Ni to the total of Ni, Co, and Mn, and is usually 0.5 or more, may be 0.6 or more, may be 0.7 or more, may be 0.8 or more, and may be 0.85 or more. Meanwhile, the "a" is usually 1.0 or less, and may be 0.9 or less.

The b signifies the molar ratio of Co to the total of Ni, Co, and Mn, and is usually 0 or more, may be 0.01 or more, may be 0.02 or more, may be 0.03 or more, may be 0.04 or more, may be 0.05 or more, may be 0.06 or more, may be 0.07 or more, and may be 0.075 or more. Meanwhile, the b is usually 0.30 or less, may be 0.25 or less, may be 0.20 or less, may be 0.15 or less, may be 0.10 or less, may be 0.09 or less, and may be 0.08 or less.

The c signifies the molar ratio of Mn to the total of Ni, Co, and Mn, and is usually 0 or more, may be 0.01 or more, may be 0.02 or more, may be 0.03 or more, may be 0.04 or more, may be 0.05 or more, may be 0.06 or more, may be 0.07 or more, and may be 0.075 or more. Meanwhile, the c is usually 0.30 or less, may be 0.25 or less, may be 0.20 or less, may be 0.15 or less, may be 0.10 or less, may be 0.09 or less, and may be 0.08 or less.

In the formula, the molar ratio a of Ni, the molar ratio b of Co, and the molar ratio c of Mn satisfy the relation of a+b+c = 1.0.

The cathode active material in the present disclosure has a composition represented by, for example, LiNi_{0.90}Mn_{0.10}O₂, LiNi_{0.5}Co_{0.2}Mn_{0.3}O₂, LiNi_{0.5}Co_{0.3}Mn_{0.2}O₂, LiNi_{0.5}Co_{0.4}Mn_{0.1}O₂, LiNi_{0.5}Co_{0.1}Mn_{0.4}O₂, LiNi_{0.6}Co_{0.2}Mn_{0.2}O₂, LiNi_{0.6}Co_{0.3}Mn_{0.1}O₂, LiNi_{0.6}Co_{0.1}Mn_{0.3}O₂, LiNi_{0.7}Co_{0.1}Mn_{0.2}O₂, LiNi_{0.7}Co_{0.2}Mn_{0.1}O₂, LiNi_{0.8}Co_{0.1}Mn_{0.1}O₂, or LiNi_{0.9}Co_{0.05}Mn_{0.05}O₂.

In the present disclosure, the composition of the cathode active material can be determined by, for example, dissolving the cathode active material in an acid, and measuring that by an ICP emission spectral analysis method (ICP-OES).

As the crystal structure of the primary particle, a layered rock salt type is preferable. The crystal structure of the layered rock salt type usually belongs to the space group R-3m.

In the present disclosure, as shown in FIG. 1 and FIG. 2, in a cross-section observation image of the cathode layer with a scanning electron microscope, the crystalline active material P configured by the primary particle includes a long side a and a short side b, an angle θ formed by the long side a and the short side b is 60° or more and 120° or less, and an aspect ratio which is a ratio of length of the long side a to the short side b is 1.2 or more. Incidentally, the long side a apparently shows the longest side of the single crystalline active material P in the cross-section SEM image of the cathode layer. The short side b is connected to the end of the long side a. The short side b shows the longest side among the sides connected to the long side a, from the appearance of the cross-section SEM image. The short side b extends from the end of the long side a to the direction crossing the direction to which the long side a extends. The long side a and the short side b may respectively extend linearly. Meanwhile, the long side a and the short side b may respectively extend curvily. When the side is curved, the length of the side indicates the distance between the both ends of the side.

In the present disclosure, in the cross-section SEM image of the cathode layer, a ratio N_{B}/N_{A} of a number N_{B} of the single crystalline active material P of which inclination of the long side a direction to in-plane direction D_{P} of the cathode layer is 0° or more and 30° or less, with respect to a number N_{A} of the single crystalline active material P is 50% or more. In other words, in the present disclosure, 50% or more of the single crystalline active material P is orientated in approximately parallel direction to the in-plane direction D_{P} of the cathode layer.

Specific measurement method for the ratio N_{B}/N_{A} is as follows. First, in the cross-section SEM image of the cathode layer, 100 pieces (N_{A} = 100 pieces) of the single crystalline active material P including a long side and a short side, wherein an angle formed by the long side and the short side is 60° or more and 120° or less, and an aspect ratio which is a ratio of length of the long side to the short side is 1.2 or more, is randomly extracted. Regarding extracted 100 pieces of the single crystalline active material P, the inclination θ_{D} of the long side a direction to the in-plane direction D_{P} of the cathode layer is respectively measured as shown in FIG. 2. Among 100 pieces of the single crystalline active material P, the number of the single crystalline active material P of which inclination θ_{D} is 0° or more and 30° or less is regarded as N_{B}. Thereby, the ratio N_{B}/N_{A} is calculated.

In the single crystalline active material in the present disclosure, the long side extends along (003) surface. When the ratio N_{B}/N_{A} is 50% or more, the (003) surface of the single crystalline active material can be arranged approximately parallel to the in-plane direction of the cathode layer, and the increase in resistance of a battery due to charge and discharge of a lithium ion battery can be suppressed.

The ratio N_{B}/N_{A} may be 56% or more, and may be 58% or more. Meanwhile, the ratio N_{B}/N_{A} is, for example, 100% or less, may be 99% or less, may be 95% or less, may be 90% or less, may be 80% or less, may be 70% or less, and may be 65% or less.

The ratio N_{C}/N_{A}, which is the ratio of a number N_{C} of the single crystalline active material of which inclination of the long side a direction to the in-plane direction of the cathode layer is over 30° and 50° or less with respect to the number N_{A} of the single crystalline active material is, for example, 40% or less, and may be 30% or less.

The ratio N_{D}/N_{A}, which is the ratio of a number N_{D} of the single crystalline active material of which inclination of the long side a direction to the in-plane direction of the cathode layer is over 50° and 90° or less with respect to the number N_{A} of the single crystalline active material is, for example, 20% or less, and may be 10% or less.

The aspect ratio of the single crystalline active material is 1.2 or more, may be 1.3 or more, may be 1.4 or more, may be 1.6 or more, may be 1.8 or more, may be 2.0 or more, may be 2.5 or more, may be 3.0 or more, may be 3.5 or more, may be 4.0 or more, may be 4.5 or more, may be 5.0 or more, may be 5.5 or more, may be 6.0 or more, may be 6.5 or more, and may be 7.0 or more. The aspect ratio may be, for example, 10.0 or less, may be 9.0 or less, and may be 8.0 or less.

The long side a of the single crystalline active material is, for example, 0.5 µm or more, may be 1.0 µm or more, may be 1.5 µm or more, may be 2.0 µm or more, may be 2.5 µm or more, may be 3.0 µm or more, may be 3.5 µm or more, and may be 4.0 µm or more. The long side a is, for example, 6.0 µm or less and may be 5.0 µm or less.

The short side b of the single crystalline active material is, for example 0.2 µm or more, may be 0.5 µm or more, may be 0.8 µm or more, may be 1.0 µm or more, may be 1.5 µm or more, may be 1.7 µm or more, and may be 1.9 µm or more. The short side b is, for example, 5.0 µm or less, may be 4.0 µm or less, may be 3.0 µm or less, and may be 2.0 µm or less.

The angle (interior angle) θ formed by the long side a and the short side b in the single crystalline active material is 60° or more and 120° or less, may be 70° or more and 110° or less, and may be 80° or more and 100° or less.

In the present disclosure, the long side a extends along the (003) surface. The (003) surface can be specified in a high angle annular cyclic dark field scanning transmission electron microscope (HAADF-STEM) image. For example, a powder body including the single crystalline active material is embedded in an epoxy resin. For example, when the resin itself embedding the powder body is made into a thin piece by measures such as argon ion milling, a sample is produced. First, the single crystalline active material is extracted with low magnitude. The long side a of the single crystalline active material is specified. Next, the (003) surface is specified by observing the single crystalline active material with high magnitude. When the angle formed by the

(003) surface and the long side a is from 0° to 30°, it is considered that the long side a extends along the (003) surface. In the STEM image, among 10 pieces of the single crystalline active material extracted randomly, when the long side a extends along the (003) surface in one or more of the single crystalline active material, it is considered that the long side a extends along the (003) surface in the whole powder body.

The angle formed by the long side a and the surface (003) in the single crystalline active material is, for example, 25° or less, may be 15° or less, may be 10° or less, may be 5° or less, may be 3° or less, and may be 1° or less. The ratio of the number of the crystalline active material of which long side a is along the (003) surface among 10 pieces of the single crystalline active material randomly extracted from the STEM image may be, for example, 20% or more, 30% or more, 40% or more, 50% or more, 60% or more, 70% or more, 80% or more, or 90% or more.

The outer shape of the single crystalline active material is, for example, a polyhedron shape. The outer shape of the single crystalline active material may be, for example, a hexahedron shape, or an octahedron shape. The outer shape of the single crystalline active material may be, for example, rectangular parallelepiped.

The primary particle includes, for example, a crystal structure belonging to a space group R-3m. The space group to which the crystal structure belongs is specified by an XRD (X-ray Diffraction) pattern. The XRD pattern is obtained by a powder XRD measurement, and the measurement conditions are as follows.
Analysis method: wide angle method
Measurement device: Smart Lab II (from Rigaku Corporation)
Measurement angle: from 10° to 120°
Bulb: CuKα
Lamp voltage: 45 kV
Lamp current: 200 mA
Measurement method: continuous method
Step: 0.02
Speed: 2°/minute
IS: 1/2
RS: 20 mm
Detection mode: one dimensional

In the single crystalline active material in the present disclosure, it is preferable that a coating layer is not formed on its surface. Examples of the coating layer may include a carbon coating layer.

The cathode active material in the present disclosure may or may not include a polycrystalline active material (polycrystal particle) configured by a secondary particle of the primary particle. The ratio of the single crystalline active material in the cathode active material is, for example, 50 weight% or more, may be 60 weight% or more, may be 70 weight% or more, may be 80 weight% or more, and may be 90 weight% or more. Meanwhile, the proportion of the single crystalline active material in the cathode active material is, for example, 100 weight% or less.

The content of the cathode active material in the cathode layer is, for example, 20 weight% or more, may be 30 weight% or more, may be 40 weight% or more, may be 50 weight% or more, may be 60 weight% or more, and may be 70 weight% or more. When the content of the cathode active material is too little, there is a possibility that sufficient energy density may not be obtained. Meanwhile, the content of the cathode active material is, for example, 95 weight% or less, may be 90 weight% or less, and may be 80 weight% or less. When the content of the cathode active material is too much, there is a possibility that the ion conductivity and the electron conductivity in the cathode layer may be relatively degraded. The content of the cathode active material in the cathode layer refers to the content of the cathode active material when the solid content overall of the cathode layer is regarded as 100 weight%.

### Method for producing cathode active material

The cathode active material in the present disclosure can be produced by performing a step of synthesizing a transition metal hydroxide, a burning step of performing a heating treatment to a mixture of the transition metal hydroxide, a Li source, and a molten salt (flux), and a crushing step of crushing a burned product.

### (a) Transition metal hydroxide synthesizing step

The transition metal hydroxide is a precursor of the cathode active material. The transition metal hydroxide may be the one obtained as a deposit by dissolving and crystallizing multiple kinds of transition metal compounds in a solvent.

There are no particular limitations on the method for synthesizing the transition metal hydroxide, and examples thereof may include a following method. First, a raw material aqueous solution of the transition metal hydroxide is prepared. Examples of the method for preparing the raw material aqueous solution may include a method in which the water soluble transition metal compound is dissolved in water. Examples of the transition metal compound may include a metal salt such as a sulfate and a nitrate. Examples of the Ni source may include NiSo₄, and Ni(NO₃)₂. Examples of the Co source may include CoSO₄, Co(NO₃)₂, and Co(NO₃)₃. Examples of the Mn source may include MnSO₄, and Mn(NO₃)₂. The composition of the raw material aqueous solution is appropriately adjusted in accordance with the intended cathode active material.

Next, in a reaction container, a fixed amount of NH₃ aqueous solution is put in, substituted with nitrogen by stirring with means such as a stirrer, so as to make non-oxidizing atmosphere. Sequentially, a sodium hydroxide aqueous solution is added to the reaction container, and the raw material aqueous solution is dropped into the reaction container while pH is maintained alkaline and controlling temperature, and thereby a reaction solution is formed. The pH of the reaction solution is adjusted, and thus the deposit (crystallized product) of the transition metal hydroxide can be formed.

After completion of the depositing reaction, temporary burning is performed. As the conditions of the temporary burning, the temperature is, for example, 120°C or more and 220°C or less, the time is, for example, 4 hours or more and 10 hours or less, and the pressure is, for example, 0.2 MPa or more and 1.0 MPa or less.

After the temporary burning, the product is washed by water and filtrated to take out the transition metal hydroxide, and a drying treatment is performed. The drying temperature is, for example, 100°C or more and 150°C or less. The drying time is, for example, 8 hours or more and 24 hours or less.

### (b) Burning step

The obtained transition metal hydroxide, a Li source, and a molten salt (flux) are mixed to obtain a mixture. The Li source is a lithium compound and examples thereof may include at least one kind selected from lithium carbonate, lithium nitrate, lithium acetate, lithium hydroxide, lithium oxide, and lithium chloride. The molar ratio of Li in the Li source to the TM included in the transition metal hydroxide is, for example, 0.8 or more and 1.2 or less, may be 0.9 or more and 1.1 or less, and may be 1.0.

The mixture usually contains a molten salt. When the mixture contains the molten salt, the primary particle can sufficiently grow. The molar ratio of Li included in the molten salt to the TM included in the transition metal hydroxide is usually 0.1 or more and 1.0 or less, may be 0.2 or more and 0.6 or less. As the molten salt, a lithium compound that is the same kind as the Li source may be used. The molten salt is, for example, lithium hydroxide. When the lithium hydroxide is used as the Li source, by setting the adding amount of the lithium hydroxide to the transition metal hydroxide to exceed the stoichiometric ratio of the intended cathode active material, the lithium hydroxide works as a flux to sufficiently grow the primary particle. The molar ratio of Li included in the Li source and the molten salt to the TM included in the transition metal hydroxide is, for example, 1.1 or more and 2.0 or less, and may be 1.2 or more and 1.6 or less. The method for mixing the transition metal hydroxide, the Li source and the molten salt may be any method. For example, they may be mixed by a mortar.

In the present disclosure, a heating treatment is performed to the mixture including the transition metal hydroxide, the Li source, and the molten salt. The burning temperature is, for example, 500°C or more and 1100°C or less, may be 650°C or more and 1100°C or less, and may be 700°C or more and 900°C or less. In the present disclosure, it is preferable to perform multi-step burning of burning the mixture containing the transition metal hydroxide, the Li source, and the molten salt at a plurality of burning temperatures. That is to easily obtain the single crystalline active material in the specified shape described above. For example, after burning is performed maintaining the specified burning temperature T1 for a specified time, it is preferable to perform burning in the next step by raising the temperature to a burning temperature T2 and maintaining the burning temperature T2 for a specified time. The burning temperature T1 described above is, for example, 500°C or more and 650°C or less, and may be 500°C or more and 600°C or less. The burning temperature T2 described above is higher than the burning temperature T1, and for example, it is 650°C or more and 1100°C or less, and may be 750°C or more and 1000°C or less. The burning may be 2 step burning, may be 3 step burning, and may be 4 step burning or more. The total of burning time in each burning step is, for example, 5 hours or more and 18 hours or less, and may be 8 hours or more and 15 hours or less.

When multi-step burning is performed, a molten salt may be added to the mixture so as to increase the Li/TM (molar ratio) in the mixture step by step. For example, to the mixture containing the transition metal hydroxide and the Li source, after burning is performed maintaining the specified burning temperature T1 for a specified time, the molten salt is added to perform burning in the next step by raising the temperature to a burning temperature T2. Next, burning is performed at the burning temperature T2 maintaining for a specified time. The molten salt may be added so that the molar ratio of Li included in the Li source and the molten salt to the TM included in the transition metal hydroxide becomes the above described range by the final burning step. For burning, any heating treatment furnace can be used, and examples thereof may include a muffle furnace and an electric furnace.

Next, the burned product is crushed to the specified particle size, such as an average particle size of 0.2 µm or less. This crushing may be crushing using an agate mortar. Next, the crushed product is dispersed in pure water and stirred to be washed. The slurry after the washing is filtrated, rinsed, and vacuum dried.

Post-annealing (re-burning) may be performed to the obtained dry powder. The post-annealing is performed under an oxygen atmosphere. The burning temperature in the post-annealing is, for example, 500°C or more and 800°C or less, and the burning time is, for example, 1 hour or more and 5 hours or less.

### (c) Crushing step

Next, the burned product is crushed and cracked to the specified granular. This cracking may be cracking using an agate mortar, and may be cracking using a mill such as a lab mill. After cracking, a treatment such as a classification treatment and a sizing treatment may be further performed. From the above, the cathode active material with the specified composition including the single crystalline active material is obtained.

### 2. Cathode layer

The cathode layer includes the above described cathode active material, and may further include a material such as a conductive material and a binder as required. The cathode layer may contain an electrolyte. The electrolyte is, for example, the later described liquid electrolyte. Meanwhile, the cathode layer may contain a solid electrolyte.

Examples of the conductive material may include graphite, acetylene black (AB), Ketjen black (registered trademark), vapor grown carbon fiber (VGCF), carbon nanotube (CNT), and graphene flake (GF). The content of the conductive material in the cathode layer to 100 parts by weight of the cathode active material is, for example, 0.1 parts by weight or more and 10 parts by weight or less.

Examples of the binder may include polyvinylidene fluoride (PVdF), a vinylidene fluoride - hexafluoro propylene copolymer (PVdF-HFP), polytetra fluoroethylene (PTFE), carboxymethylcellulose (CMC), polyacrylic acid (PAA), polyvinyl alcohol (PVA), polyvinyl pyrrolidone (PVP), polyoxyethylene alkylether, and derivatives of these. The content of the binder in the cathode layer to 100 parts by weight of the cathode active material is, for example, 0.1 parts by weight or more and 10 parts by weight or less.

The thickness of the cathode layer is, for example, 0.1 µm or more and 1000 µm or less, may be 1 µm or more and 500 µm or less, and may be 30 µm or more and 100 µm or less.

The cathode layer can be formed by, for example, the method described in "C. Method for producing the cathode layer".

In the cross-section SEM image of the cathode layer in the present disclosure, there may be a single crystalline active material not observed as the specified shape described above. Examples of such a single crystalline active material may include one having substantially the same outer shape of the single crystalline active material observed in the specified shape, but a particle appearing as a small particle or a dot because it is cut at the edge of the active material particle when taking out the cross-section of the cathode layer.

### B. Lithium ion battery

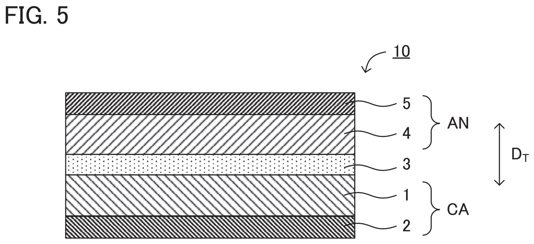

The lithium ion battery in the present disclosure includes the above described cathode layer for lithium ion battery. In other words, the present disclosure can provide a battery wherein a cathode layer, an electrolyte layer, and an anode layer are layered in this order, and the cathode layer is the above described cathode layer. FIG. 5 is a schematic cross-sectional view exemplifying the lithium ion battery in the present disclosure. The lithium ion battery 10 shown in FIG. 5 includes layers in the order of anode current collector 5, anode layer 4, electrolyte layer 3, cathode layer 1, and cathode current collector 2 along with thickness direction D_{T}, wherein the anode current collector 5 and the anode layer 4 configure anode AN, and the cathode layer 1 and the cathode current collector 2 configure cathode CA.

According to the present disclosure, the lithium ion battery includes the above described cathode layer, and thus the increase in resistance of the battery due to charge and discharge can be suppressed.

### 1. Cathode layer

The cathode layer is in the same contents as those described in "A. Cathode layer".

### 2. Anode layer

The anode layer contains at least an anode active material, and may contain at least one of an electrolyte, a conductive material and a binder, as required. Examples of the anode active material may include a silicon-based active material such as Si and a Si alloy, tin and a tin alloy, and silicon oxide; a carbon-based active material such as graphite and hard carbon; various oxide-based active materials such as lithium titanate; and metal lithium, and a lithium alloy.

The anode active material may be in a granular shape, and may be in a sheet shape. The average particle size of the anode active material may be, for example, 1 µm or more. The average particle size of the anode active material may be, for example, 30 µm or less.

Examples of the conductive material, the binder, and the electrolyte used for the anode layer may include those described for the cathode layer above.

### 3. Electrolyte layer

The electrolyte layer is a layer formed between the cathode layer and the anode layer, and contains at least an electrolyte. The electrolyte is, for example, an electrolyte solution (liquid electrolyte).

Examples of the electrolyte may include a non-aqueous liquid electrolyte. The non-aqueous liquid electrolyte contains, for example, a lithium salt and a non-aqueous solvent. Examples of the lithium salt may include an inorganic lithium salt such as LiPF₆, LiBF₄, LiClO₄, and LiAsF₆; and an organic lithium salt such as LiCF₃SO₃, LiN(SO₂CF₃)₂, LiN(SO₂C₂F₅)₂, and LiC(SO₂CF₃)₃.

Examples of the non-aqueous solvent may include a carbonate-based solvent such as ethylene carbonate (EC), propylene carbonate (PC), butylene carbonate (BC), dimethyl carbonate (DMC), diethyl carbonate (DEC), and ethyl methyl carbonate (EMC). The non-aqueous solvent may be a mixture of cyclic carbonate including high dielectric constant and high viscosity such as EC and PC with chain carbonate including low dielectric constant and low viscosity such as DMC, DEC, and EMC. The concentration of the lithium salt in the non-aqueous liquid electrolyte is, for example, 0.3 M or more and 5 M or less. Also, the non-aqueous liquid electrolyte may include an ionic solution. Examples of the ionic solution may include sulfonium salt, ammonium salt, pyridinium salt, piperidinium salt, pyrrolidinium salt, morpholinium salt, phosphonium salt, and imidazolium salt.

Examples of other electrolytes may include a water-based liquid electrolyte. The water-based liquid electrolyte is an electrolyte including water as a main component of the solvent. The proportion of water to all the solvent is, for example, 50 mass% or more, and may be 70 mass% or more. Examples of the lithium salt used in the water-based liquid electrolyte may include an imide-based liquid electrolyte such as lithiumbis(fluorosulfonil)imide, and lithiumbis(trifluoromethanesulfonil)imide. The concentration of the lithium salt in water-based liquid electrolyte is, for example, 1 M or more and 25 M or less.

The electrolyte layer may include a separator impregnated with the above described liquid electrolyte. By arranging the separator, occurrence of short circuit can be inhibited. The separator is, for example, a porous film. Examples of the materials of the separator may include a resin such as polyethylene, polypropylene, polyester, polyvinyl alcohol, cellulose, and polyamide. Also, the electrolyte layer may contain a solid electrolyte. Examples of the solid electrolyte may include an organic electrolyte such as a polymer electrolyte and a gel electrolyte; and an inorganic solid electrolyte such as a sulfide solid electrolyte, an oxide solid electrolyte, and a halide solid electrolyte.

### 4. Cathode current collector

Examples of the material for the cathode current collector may include SUS, Cr, Au, Pt, Zn, aluminum, copper, nickel, iron, titanium, and carbon. The thickness of the cathode current collector is, for example, 0.1 µm or more and 100 µm or less. Examples of the shape of the cathode current collector may include a foil shape, a mesh shape, and a porous shape. There are no particular limitations on the shape of the cathode current collector in a plan view, and examples thereof may include a circle shape, an oval shape, a square shape, and any polygonal shapes. The configuration of the cathode current collector may be the one in which a shock absorbing layer, an elastic layer, or a PTC (Positive Temperature Coefficient) thermistor layer is arranged on its surface.

### 5. Anode current collector

Examples of the material for the anode current collector may include SUS, aluminum, copper, nickel, iron, titanium, and carbon. Also, the thickness of the anode current collector varies depending on the shape, but for example, it is 1 µm or more and 50 µm or less. The shape of the anode current collector may be a foil shape or a plate shape. There are no particular limitations on the shape of the anode current collector in a plan view, and examples thereof may include a circle shape, an oval shape, a square shape, and any polygonal shapes. The configuration of the anode current collector may be the one in which a shock absorbing layer, an elastic layer, or a PTC thermistor layer is arranged on its surface.

### 6. Lithium ion battery

The battery in the present disclosure may include an outer package for storing a power generation elements (the cathode layer, the electrolyte layer, and the anode layer). Examples of the outer package may include a case type outer package and a laminate type outer package.

The lithium ion battery in the present disclosure is usually a secondary battery. When a set of the cathode layer, the electrolyte layer and the anode layer is regarded as a power generating unit, the lithium ion battery in the present disclosure may be a single battery including just one of the power generating unit, and may be a layered battery including two or more thereof. The layered battery may be a monopolar layered battery (layered battery connected in parallel), and may be a bipolar layered battery (layered battery connected in series).

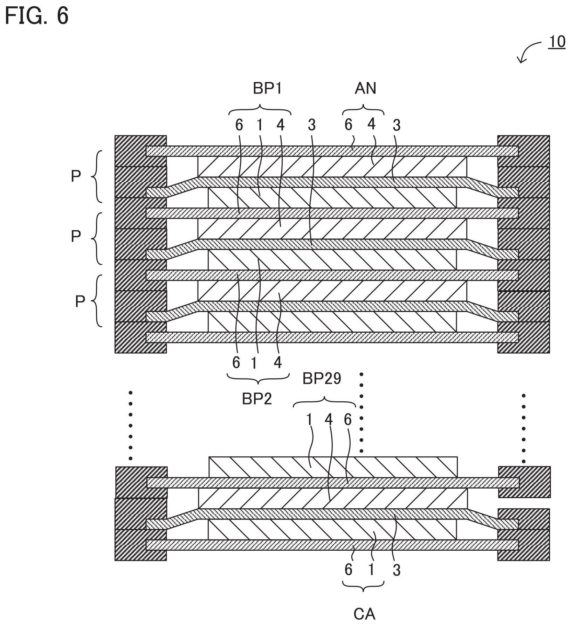

FIG. 6 is a schematic cross-sectional view exemplifying a case where the lithium ion battery in the present disclosure is a bipolar battery. Lithium ion battery 10 shown in FIG. 6 includes a plurality of layered power generating unit P. The power generating unit P includes cathode layer 1, anode layer 4, and electrolyte layer 3 arranged between the cathode layer 1 and the anode layer 4. The lithium ion battery 10 shown in FIG. 6 includes bipolar electrodes BP (from BP 1 to BP 29) as the electrode. Further, the lithium ion battery 10 includes cathode side end electrode CA and anode side end electrode AN. The bipolar electrode BP includes current collector 6, cathode layer 1, and anode layer 4. The cathode layer 1 is arranged on one surface of the current collector 6, and the anode layer 4 is arranged on the other surface of the current collector 6. The cathode side end electrode CA includes current collector 6 and cathode layer 1. This cathode layer 1 is arranged on one surface of the current collector 6. The anode side end electrode AN includes current collector 6 and anode layer 4. This anode layer 4 is arranged on one surface of the current collector 6.

The lithium ion battery 10 in the present disclosure may include just one of the bipolar electrode BP, and may include two or more thereof. Meanwhile, the battery in the present disclosure may not include the bipolar electrode.

The application of the lithium ion battery is not particularly limited, and examples thereof may include a power source for vehicles such as hybrid electric vehicles (HEV), plug-in hybrid electric vehicles (PHEV), battery electric vehicles (BEV), gasoline-fueled automobiles and diesel powered automobiles. In particular, it is preferably used as a power source for driving hybrid electric vehicles (HEV), plug-in hybrid electric vehicles (PHEV), and battery electric vehicles (BEV). Also, the battery may be used as a power source for moving bodies other than vehicles (such as rail road transportation, vessel and airplane), and may be used as a power source for electronic products such as information processing equipment.

### C. Method for producing cathode layer

The method for producing a cathode layer in the present disclosure is a method for producing the above described cathode layer, the method including: an applying step of applying a cathode slurry including the cathode active material that contains the single crystalline active material, and a solvent to obtain a cathode layer precursor, and an orientating step of orientating the single crystalline active material so that an inclination of the long side direction to in-plane direction of the cathode layer becomes 0° or more and 30° or less by exposing the cathode layer precursor under magnetic field.

According to the present disclosure, the single crystalline active material can be easily orientated so that the inclination of the long side to the in-plane direction of the cathode layer is approximately parallel (0° or more and 30° or less).

### 1. Applying step

In the present step, for example, a cathode slurry is obtained by mixing the cathode active material including the single crystalline active material, and a solvent, and the cathode slurry is applied on a cathode current collector to obtain a cathode layer precursor that is a coated layer. The single crystalline active material and the cathode active material are in the same contents as those described in "A. Cathode layer 1. Cathode active material".

Examples of the solvent may include N-methyl pyrrolidone (NMP), tetralin, diisobutyl ketone, butyl butyrate, mesitylen, heptane, dibutyl ether, decane, dodecane, isodecane, and toluene, and two or more of these components may be included.

### 2. Orientating step

The present step is a step of orientating the single crystalline active so that an inclination of the long side direction to in-plane direction of the cathode layer becomes 0° or more and 30° or less by exposing the cathode layer precursor under magnetic field. FIG. 4 is a schematic view showing a state of applying the magnetic field in the present step. As shown in FIG. 4, in the applying step, for example, by applying the slurry including the single crystalline active material P on the cathode current collector 2, a structure body 20 including the cathode current collector 2 and the cathode layer precursor 1' is obtained. After that, S pole 30a and N pole 30b of a neodymium magnet is fixed above and below the structure body 20, and exposed under the magnetic field to adjust the direction of the long side direction of the single crystalline active material P to approximately parallel direction with respect to the in-plane direction (in-plane direction of current collector) of the cathode layer. The magnitude of the magnetic field is, for example, 5 tesla or more and 10 tesla or less. The time of exposing under the magnetic field is, for example, 1 minute or more and 20 minutes or less, and may be 1 minute or more and 10 minutes or less.

After the orientating step, a drying treatment and a pressing treatment are performed as required. Examples of the pressing treatment may include a roller pressing and a flat plate pressing. Incidentally, when the drying treatment and the pressing treatment are performed without performing the orientating step, the ratio N_{B}/N_{A} is usually less than 50%, and may be 40% or less. From the method described above, the above described cathode layer is produced.

Incidentally, the present disclosure is not limited to the embodiments. The embodiments are exemplification, and any other variations are intended to be included in the technical scope of the present disclosure if they have substantially the same constitution as the technical idea described in the claims of the present disclosure and have similar operation and effect thereto.

### Examples

### [Example 1]

### <Synthesis of cathode active material>

A cathode active material having the composition represented by LiNi_{0.90}Mn_{0.10}O₂ was obtained by the method shown below.

### <Preparation of raw material aqueous solution>

First, NiSO₄ and MnSO₄ were dissolved in an ion exchanged water to prepare a raw material aqueous solution. The blending ratio of NiSO₄ and MnSO₄ was adjusted so that Ni/Mn ratio became 90/10 atm%. The concentration of the raw material aqueous solution was 0.2 mol%.

### <Dehydration and temporary burning>

In a reaction container fixed amount of NH₃ aqueous solution was put in, and substituted with nitrogen by stirring with a stirrer. In the reaction container, NaOH was added to adjust the pH of the aqueous solution to alkali. The pH in the reaction container was controlled to be constant, and the raw material aqueous solution was dropped while controlling the temperature to deposit a transition metal hydroxide. After the deposition reaction completed, dehydration and temporary burning were performed to the deposit in the below temperature and pressure conditions.
- Temperature : 120°C
- Time: 8 hours
- Pressure: 1.0 MPa

### <Collection of precursor>

The deposit was washed with water after the temporary burning. The deposit washed with water was filtrated to take out the transition metal hydroxide. Next, the product was dried at 110°C for 12 hours to evaporate moisture (dried product). Thereby, a precursor was prepared.

### <Mixture of Li raw material and molten salt>

The obtained precursor (transition metal hydroxide) and LiOH as a Li source were mixed with a mortar. LiOH as the Li source was mixed so that a ratio (molar ratio) of Li included in the Li source to the total amount of the transition metal kind (Ni, Mn) included in the transition metal hydroxide became 1.0. Further, LiOH as a molten salt was mixed so that the ratio (molar ratio) of Li in the molten salt to the total amount of the transition metal kind included in the transition metal hydroxide became 0.6. In other words, the total addition amount of LiOH was made an amount so that the ratio (molar ratio) of Li included in LiOH to the total amount of the transition metal kind included in the transition metal hydroxide was 1.6. Thereby, at the time of burning, the excessive lithium compound forms the molten salt to promote the single crystallization of the cathode active material.

### <Burning>

A heat treatment (burning) was performed to the mixture. Burning was performed in a muffle furnace at 500°C for 3 hours and then 780°C for 12 hours (burning step). Next, the burned product was crushed with an agate mortar to the particle size of 0.2 mm or less, and then dispersed in a pure water of 500 mL and stirred hard for one minute to obtain a slurry. The slurry was filtrated with a buchner funnel and a filter paper, rinsed with pure water of 500 mL, and the obtained cake was vacuum dried at 90°C. After drying, the obtained dry powder was burned under oxygen flow at 500°C for 3 hours (re-burning). The burned product was crushed with an agate mortar, and cracked to the specified particle size (crushing). Thereby, a particle having a composition represented by LiNi_{0.90}Mn_{0.10}O₂ was obtained.

### [Production of cathode]

A slurry for cathode including the particle as a cathode active material, acetylene black, and a NMP solvent was applied on an aluminum foil that is a cathode current collector, using a film applicator with film thickness adjusting function (from Allgood Corporation) to obtain a structure body including the cathode current collector and the cathode layer precursor (applying step). The neodymium magnet is fixed above and below the structure body, and the structure body was exposed under the magnetic field of about 5 tesla for 10 minutes (orientating step). After exposing under the magnetic field, a drying treatment for letting out the NMP solvent was performed for 5 minutes on a hot plate at 80°C, and then a pressing treatment (pressing treatment using 3-ton roll pressing for 3 times) was performed. Thereby, a cathode including the cathode current collector (aluminum foil) and a cathode layer was obtained.

The obtained cathode was cut in a thickness direction by ion milling to take out the cross-section of the cathode layer. The cross-section of the cathode layer was observed by a scanning electron microscope (scanning electron microscope SU8230 from Hitachi High-Technologies Corporation) at an acceleration voltage of 1 kV. In the cross-section SEM image, a single crystalline active material configured by a crystalline primary particle was observed. 100 pieces (that is, N_{A} = 100) of the single crystalline active material including parts that can be judged as a line segment of two side of a short side and a long side, an angle formed by the short side and the long side was 60° or more and 120° or less, and an aspect ratio that was a ratio of length of the long side to length of the short side was 1.2 or more, was randomly selected. Among 100 pieces of the single crystalline active material, the number N_{B} of the primary particle of which inclination of the long side direction to the in-plane direction of the cathode layer (in-plane direction of metal foil) was 0° or more and 30° or less was counted. The ratio of the number N_{B} to the number N_{A}, which is N_{B}/N_{A}, was calculated. The results are shown in Table 1.

### [Production of battery]

An anode mixture paste including a natural graphite that is an anode active material was applied on a surface of a metal foil that is an anode current collector using a film applicator with film thickness adjusting function (from Allgood Corporation). After that, the product was dried by a dryer at 80°C for 5 minutes, and an anode including an anode layer was produced on the anode current collector. LiPF₆ solution of 1 M containing LiPF₆ as an electrolyte, and ethylene carbonate (EC), dimethyl carbonate (DMC), and ethyl methyl carbonate (EMC) as a solvent in a ratio of EC/DMC/EMC = 3/4/3 vol%, was prepared as a liquid electrolyte. The cathode, a separator, and the anode were layered, the separator was impregnated with the liquid electrolyte, and a small size laminate cell in which power generating elements were stored in a pouch made of an Al laminate film, was produced.

### [Example 2]

A cathode was produced in the same manner as in Example 1, except that the time for exposing the structure body under the magnetic field in the orientating step at the time of producing the cathode was changed to 3 minutes. A laminate cell having the same structure as in Example 1 was obtained except that the obtained cathode was used.

### [Example 3]

A cathode was produced in the same manner as in Example 1, except that the time for exposing the structure body under the magnetic field in the orientating step at the time of producing the cathode was changed to 1 minute. A laminate cell having the same structure as in Example 1 was obtained except that the obtained cathode was used.

### [Comparative Example 1]

A cathode was produced in the same manner as in Example 1, except that the orientating step was not performed at the time of producing the cathode. A laminate cell having the same structure as in Example 1 was obtained except that the obtained cathode was used.

### [Comparative Example 2]

A cathode was produced in the same manner as in Example 1, except that the time for exposing the structure body under the magnetic field in the orientating step at the time of producing the cathode was changed to 20 seconds. A laminate cell having the same structure as in Example 1 was obtained except that the obtained cathode was used.

### [Evaluation]

The measurement of IV resistance after the initial aging and after the cycle test of 100 cycles was respectively performed for the laminate cells. The cycle test was performed for 100 cycles in the below conditions.
- Surrounding temperature : 60°C
- Cycle number: 100
- Current rate: 0.3 C
- Voltage range: from 4.25 V to 2.5 V

The laminate cells were charged until SOC 50%, and then discharged and charged at the current amount of 0.3 C, 0.5 C, 0.7 C, and 1.0 C at 25°C, and the average resistance estimated from the potential drop/rise after 1 s was determined as the IV resistance (after the initial aging). The above measurement was performed after the cycle test of 100 cycles (after 100 cycles). The results are shown in Table 1.

**[Table 1]**

| | N_{B}/N_{A}[%] | After initial aging 25°C 1s IV resistance R1 [Ω] | 60°C, After 100 cycles 25°C 1s IV resistance R2 [Ω] | R2-R1 [Ω] |
|---|---|---|---|---|
| Example 1 | 65 | 0.8 | 2.5 | 1.7 |
| Example 2 | 58 | 0.6 | 3.4 | 2.8 |
| Example 3 | 56 | 1 | 3.8 | 2.8 |
| Comp. Ex. 1 | 47 | 1.6 | 6.2 | 4.6 |
| Comp. Ex. 2 | 35 | 1.1 | 5.3 | 4.2 |

As shown in Table 1, it was confirmed that the resistance increase after the cycles was suppressed in the batteries including the cathode layer of which N_{B}/N_{A} was 50% or more (Examples 1 to 3) compared to the batteries including the cathode layer of which N_{B}/N_{A} was less than 50% (Comparative Examples 1 and 2).

### Reference Sings List

- 1: cathode layer
- 2: cathode current collector
- 3: electrolyte layer
- 4: anode layer
- 5: anode current collector
- 10: lithium ion battery

## Claims

1. A cathode layer to be used in a lithium ion battery, the cathode layer **characterized by** comprising:
a single crystalline active material configured by a crystalline primary particle containing Li, TM, which is a transition metal, and O as a cathode active material, wherein
in a cross-section observation image of the cathode layer by a scanning electron microscope,
the single crystalline active material includes a long side and a short side, an angle formed by the long side and the short side is 60° or more and 120° or less, and an aspect ratio which is a ratio of length of the long side to the short side is 1.2 or more,
the long side of the single crystalline active material extends along (003) surface,
and a ratio N_{B}/N_{A} of a number N_{B} of the single crystalline active material of which inclination of the long side direction to in-plane direction of the cathode layer is 0° or more and 30° or less, with respect to a number N_{A} of the single crystalline active material is 50% or more.

2. The cathode layer according to claim 1, **characterized in that** a length of the long side of the single crystalline active material is 0.5 µm or more.

3. The cathode layer according to claim 1, wherein the ratio N_{B}/N_{A} is 56% or more and 65% or less.

4. The cathode layer according to claim 1, **characterized in that** an outer shape of the single crystalline active material is a rectangular parallelepiped.

5. The cathode layer according to claim 1, **characterized in that** the primary particle includes at least Ni as the TM.

6. The cathode layer according to claim 5, **characterized in that** the primary particle contains at least one kind of Co and Mn as the TM.

7. The cathode layer according to claim 5, **characterized in that** a molar ratio of the Ni to the TM is 0.5 or more.

8. The cathode layer according to claim 1, **characterized in that** a ratio of the single crystalline active material in the cathode active material is 50 weight% or more.

9. The cathode layer according to claim 1, **characterized in that** the primary particle includes a layered rock salt type crystal structure.

10. The cathode layer according to claim 1, **characterized in that** the primary particle includes a composition represented by LiₓNiₐCo_{b}Mn_{c}O_{y}, in which 0.1 ≤ x ≤ 1.5, 0.5 ≤ a ≤ 1.0, 0 ≤ b ≤ 0.3, 0 ≤ c ≤ 0.3, a+b+c = 1.0, and 1.5 ≤ y ≤ 2.1.

11. A lithium ion battery **characterized by** comprising the cathode layer according to any one of claims 1 to 10.

12. A method for producing the cathode layer according to any one of claims 1 to 10, the method **characterized by** comprising:
an applying step of applying a cathode slurry including the cathode active material that contains the single crystalline active material to obtain a cathode layer precursor, and
an orientating step of orientating the single crystalline active material so that an inclination of the long side direction to in-plane direction of the cathode layer becomes 0° or more and 30° or less by exposing the cathode layer precursor under magnetic field.
